# EUROPEAN PATENT APPLICATION

(11) **EP 1 107 642 A2**
(43) Date of publication of application: **13.06.2001**
(21) Application number: 00306107.4
(22) Date of filing: 18.07.2000
(51) Int. Cl.: H04R 19/00

(54) **Condenser microphone**

(30) Priority: 07.12.1999 KR 9955502
(71) Applicant: Won-Il Communics Co., Ltd, Seoul 140-111 (KR)
(72) Inventor: Kim, Jong-Kyu, Mapo-ku, Seoul 121-210 (KR)
(74) Representative: Neobard, William John

(57) **Abstract**

A condenser microphone constructed to convert the variation of capacitance between a diaphragm and a polar plate caused due to sound wave into an electrical signal, including: a printed circuit board having predetermined patterns formed on the both surfaces thereof and connected to each terminal of an FET; a metal ring for electrically connecting the gate of the FET and the polar plate; and a case electrically connected to a polar ring and for electrically connecting the diaphragm vibrated by the sound wave to the source of the FET. Accordingly, the condenser microphone is capable of realizing the automation of a manufacturing process thereof and reducing the disconnection of each terminal of the FET.

## Description

The present invention relates to a condenser microphone capable of converting the variation of capacitance caused by sound wave into an electrical signal. Embodiments of the condenser microphone are capable of achieving automation in a manufacturing process and reducing the damage of a field effect transistor (hereinafter, referred to as 'FET') during the manufacturing process.

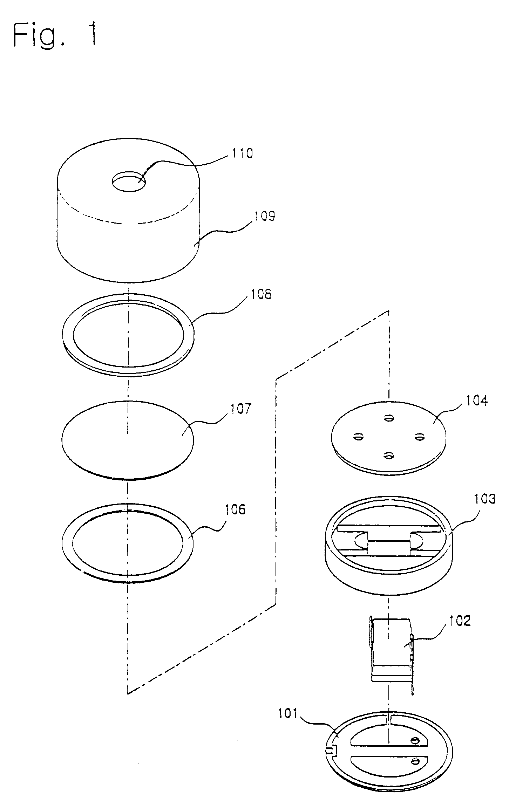

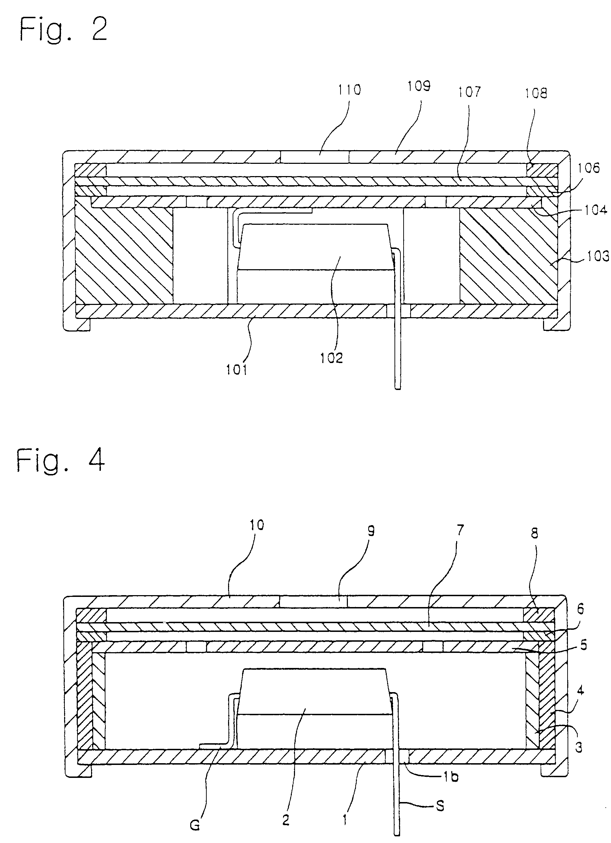

As shown in Figs. 1 and 2, a conventional condenser microphone comprises a printed circuit board 101, an FET 102 for converting the change of electric potential due to the variation of capacitance into an electrical signal, a base 103, a polar plate 104 on which a plurality of through holes are formed, a spacer 106, a polar ring 108, a diaphragm 107 being vibrated by the sound wave flowing therein, and a case 109 on which a sound wave inflow hole 110 is drilled.

The conventional condenser microphone is manufactured in such a manner that after the polar ring 108, the diaphragm 107, the spacer 106 and the polar plate 104 are sequentially assembled in the case 109, and the printed circuit board 101 on which the FET 102 is coupled is finally assembled therein, the one end of the case 109 is folded.

In this case, the gate of the FET 102 is electrically connected to the polar plate 104, and the source and drain thereof are exposed to the outside of the printed circuit board 101. Before the printed circuit board 101 is assembled in the case 109, the source and drain of the FET 102 are folded downward to be inserted into the through holes of the printed circuit board 101. Next, in order for the FET 102 to be temporarily secured on the printed circuit board 101, the source and drain of the FET 102 are again folded to surround the printed circuit board 101. Then, the gate of the FET 102 is folded upward such that upon assembling the FET 102 in the case 109, it is connected to the polar plate 104. Of course, the source and drain of the FET 102 should be folded back to the original state thereof after a manufacturing process.

In the conventional condenser microphone, however, since the source and drain of the FET 102 are inserted into the through holes of the printed circuit board 101 to be temporarily secured on the printed circuit board 101 and then folded back, there arise some problems that the automation of the manufacturing process can not be realized and the source and drain of the FET 102 are likely to be disconnected due to the repetitive folding thereof.

Moreover, since the gate of the FET 102 and the polar plate 104 are connected in a point contact, the connection there between is substantially unstable, and if there exists a slight gap between the FET 102 and the polar plate 104, connection failure may be caused.

An embodiment of the invention provides a condenser microphone capable of realizing the automation of a manufacturing process by the connection of a FET to a printed circuit board by cream soldering and reducing the damage of the FET during the manufacturing process to improve production efficiency thereof.

Another embodiment of the invention provides a condenser microphone capable of improving the connection method of a polar plate and a FET to prevent connection failure between the polar plate and the gate of the FET.

According to the present invention, there is provided a condenser microphone constructed to convert the variation of capacitance between a diaphragm and a polar plate caused by sound wave into an electrical signal, which comprises: a printed circuit board having predetermined patterns formed on the both surfaces thereof and connected to each terminal of an FET; a metal ring for electrically connecting the gate of the FET and the polar plate; and a case electrically connected to a polar ring and for electrically connecting the diaphragm vibrated by the sound wave to the source of the FET.

Preferably, the each terminal of the FET is connected to each pattern of the printed circuit board in such a manner that the gate thereof is folded and soldered to be connected to one of the patterns of the printed circuit board and the source and drain thereof are inserted to be passed through the printed circuit board and then soldered to be connected to ones of the patterns thereof.

Preferably, the base ring of an insulation material should be interposed between the metal ring and the case, and a spacer of an insulation material should be interposed between the polar plate and the diaphragm so that the polar plate and the diaphragm are insulated and spaced out a predetermine distance apart from each other.

An embodiment of the invention will now be described by way of example only with reference to the accompanying drawings, in which:
Fig. 1 is a separated perspective view illustrating a conventional condenser microphone;
Fig. 2 is a sectional view of Fig.1;
Fig. 3 is a separated perspective view illustrating a condenser microphone according to the present invention;
Fig. 4 is a sectional view of Fig. 3; and
Figs. 5a and 5b are plan and bottom views illustrating the printed circuit board employed in the condenser microphone according to the present invention.

In the various figures, like references refer to like parts.

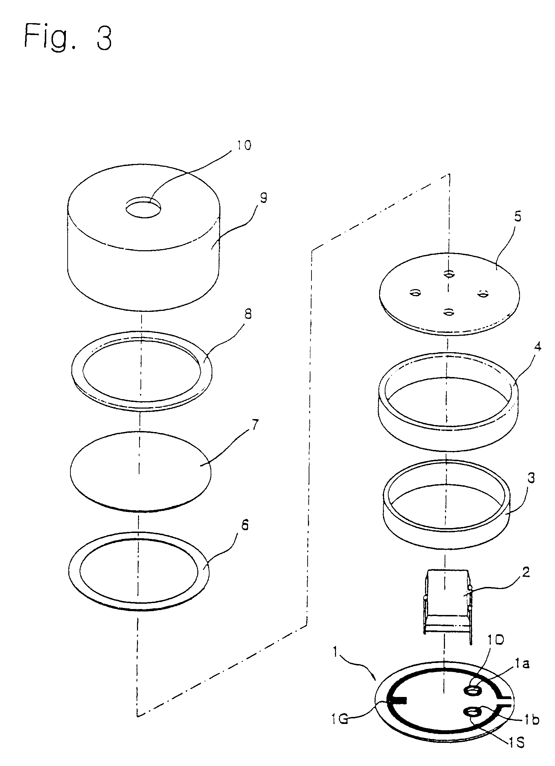

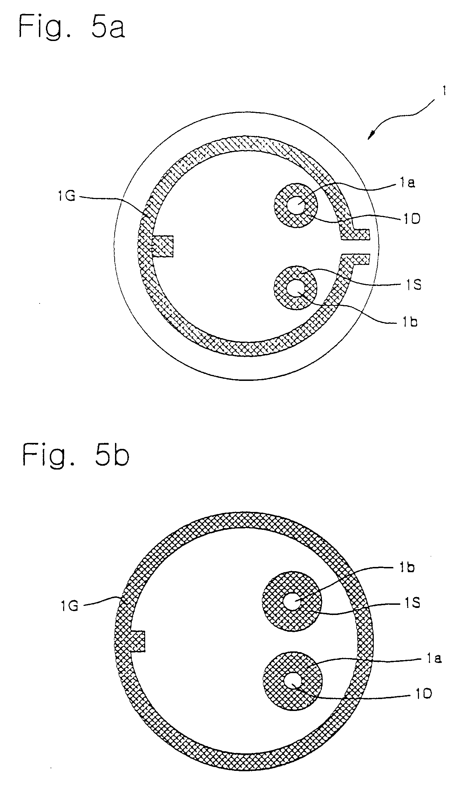

The condenser microphone according to the present invention is configured, as shown in Figs. 3 and 4, in such a manner that the gate of an FET 2, which is connected to a pattern 1G of a printed circuit board 1, and the source and drain of the FET, which are inserted into the through holes 1a and 1b of the printed circuit board 1 are soldered by means of cream or soft solder, to the pattern 1G, 1S, 1D thereof respectively.

In this case, on the top surface of the printed circuit board 1, as shown in Fig. 5a, the predetermined patterns 1G, 1S, 1D are formed to be connected to each terminal of the FET 2 and a metal ring 3, and as the pattern 1G connected to the gate of the FET 2 is the one which is electrically connected to the pattern connected to the metal ring 3, it is denoted by the same reference numeral. In the centers of the patterns 1S, 1D, the through holes 1a and 1b are drilled through the printed circuit board 1 from top to bottom. And on the bottom surface of the printed circuit board 1, as shown in Fig. 5b, the pattern 1S is formed to be electrically connected to the source of the FET 2, i.e. ground of the FET 2, as well as to the case 9.

In other words, in process of connecting the FET 2 to the printed circuit board 1, after the source S and the drain D of the FET 2 are folded downward to be inserted into the through holes 1a, 1b and the gate G thereof is folded horizontally to be in contact with the pattern 1G, the each terminal G, D, S of the FET 2 is soldered to be electrically connected to each pattern 1G, 1D, 1S of the printed circuit board 1 by using a soft or cream solder.

On the printed circuit board 1 on which the FET 2 is assembled, the metal ring 3 made of a conductive material, a base ring 3 of an insulation material, a polar plate 5 on which a plurality of holes are drilled, a spacer of an insulation material, a diaphragm 7 of a high molecular film and a polar ring 8 are electrically connected or built up to be insulated from each other. A case 9 through which a sound wave inflow hole 10 is drilled is folded to surround the circumference of the printed circuit board 1, while containing the components having the polar ring 8.

In other words, the gate G of the FET 2 is electrically connected to the pattern 1G of the printed circuit board 1, the metal ring 3 and the polar plate 5, and the source S thereof is electrically connected to the pattern IS of the printed circuit board 1, the case 9, the polar ring 8 and the diaphragm 7.

Next, an explanation of an operation of the condenser microphone thus connected will be discussed.

While the diaphragm 7 is vibrated due to the sound wave flowing through the sound wave inflow hole 10, the interval between the diaphragm 7 and the polar plate 5 is changed to thereby vary the capacitance there between.

Accordingly, as the electric potential of the polar plate 5 is varied corresponding to the flowing of the sound wave and input to the gate G of the FET 2, the electric current flowing from the source S to the drain D of the FET 2 is amplified corresponding to the sound wave.

As a result, the condenser microphone can convert the flowing of the sound wave through the sound wave inflow hole 10 into the electrical signal and amplify the converted electrical signal.

As discussed above, a condenser microphone according to the present invention is capable of realizing the automation of a manufacturing process and reducing the disconnection of the terminals of a FET during the manufacturing process as well by the connection of an FET to a printed circuit board by cream soldering.

It will be apparent to those skilled in the art that various modifications and variations can be made in a condenser microphone of the present invention without departing from the spirit or scope of the invention. Thus, it is intended that the present invention cover the modifications and variations of this invention provided they come within the scope of the appended claims and their equivalents.

## Claims

1. A condenser microphone for converting a variation of capacitance between a diaphragm and a polar plate caused by sound wave into an electrical signal, comprising:
a printed circuit board having predetermined patterns formed on the both surfaces thereof and connected to each terminal of an FET;
a metal ring for electrically connecting the gate of said FET and said polar plate; and
a case electrically connected to a polar ring and for electrically connecting said diaphragm vibrated by the sound wave to the source of said FET.

2. The condenser microphone according to claim 1, wherein each terminal of said FET is soldered to each of said predetermined patterns of said printed circuit board.

3. The condenser microphone according to claim 1 or 2, wherein said gate of said FET is folded and soldered to be connected to one of said predetermined patterns of said printed circuit board.

4. The condenser microphone according to claim 1 or 2, wherein said source and drain of said FET are inserted to be passed through said printed circuit board and then soldered to be connected to ones of said predetermined patterns of said printed circuit board.

5. The condenser microphone according to claim 1, wherein a base ring of an insulation material is interposed between said metal ring and said case.

6. The condenser microphone according to claim 1, wherein between said polar plate and said diaphragm, a spacer of an insulation material is interposed so that said polar plate and said diaphragm are insulated and spaced by a predetermined distance apart from each other.
